# FASCICULE DE BREVET EUROPEEN

(11) **EP 3 438 595 B1**
(45) Date de publication et mention de la délivrance du brevet: **11.08.2021**
(21) Numéro de dépôt: 18184136.2
(22) Date de dépôt: 18.07.2018
(51) Int. Cl.: F28F 9/00, F16J 15/00, F16L 27/00, F28F 9/02, F28F 9/26, H05K 7/20

(54) **JONCTION DE PORTIONS DE CIRCUIT DE REFROIDISSEMENT POUR UN ENSEMBLE DE DEUX BOITIERS**
VERBINDUNG VON ABSCHNITTEN EINES KÜHLKREISLAUFS FÜR EINE ANORDNUNG VON ZWEI GEHÄUSEN
JUNCTION BETWEEN PORTIONS OF COOLING CIRCUIT FOR A SET OF TWO UNITS

(30) Priorité: 02.08.2017 FR 1757431
(43) Date de publication de la demande: 06.02.2019
(73) Titulaire: Valeo Siemens eAutomotive France SAS, 95800 Cergy (FR)
(72) Inventeur: POUILLY, Aurélien, 78300 Poissy (FR); HARY, Sébastien, 95340 Persan (FR); MERCIER, Philippe, 49240 Avrille (FR)
(74) Mandataire: Argyma

(56) Documents cités:
- EP-A1- 2 966 396
- WO-A1-2016/049776
- WO-A1-2017/081243
- DE-A1-102015 226 023

## Description

### DOMAINE TECHNIQUE ET OBJET DE L'INVENTION

La présente invention se rapporte au domaine des équipements électriques, en particulier pour véhicules électriques ou hybrides, et concerne plus précisément les circuits de refroidissement à fluide, notamment à eau liquide, mis en oeuvre pour éviter toute surchauffe de systèmes électriques, tels que des onduleurs reliés au moteur dans des systèmes de motorisation électrique.

En particulier, la présente invention vise la jonction entre des portions de circuit de refroidissement à fluide intégrées à des boîtiers de systèmes électriques juxtaposés, dont, par exemple, un onduleur. EP 2 966 396 divulgue un ensemble permettant la jonction entre des portions de circuit de refroidissement selon le préambule de la revendication 1.

### ETAT DE LA TECHNIQUE

Comme cela est connu, dans des systèmes de motorisation électriques, il est nécessaire de prévoir des moyens de refroidissement de certains systèmes électriques, en particulier de l'onduleur alimentant le moteur électrique et dudit moteur électrique. A cette fin, selon l'état de l'art, un circuit de refroidissement à fluide, en particulier à eau liquide, est intégré au système de motorisation électrique.

Selon une technologie connue, un circuit de refroidissement à eau comprend des canalisations pour faire circuler de l'eau dans le boîtier enfermant l'onduleur, d'une part, puis un tuyau permet d'acheminer l'eau jusqu'au châssis du moteur. Au moyen des échanges thermiques entre les composants chauds et l'eau plus froide, l'objectif est de refroidir lesdits composants chauds.

Or, le volume disponible dans les véhicules est réduit, y compris pour les systèmes de motorisation électriques, et, les systèmes électriques se complexifiant, il est devenu courant que le boîtier de l'onduleur soit accolé au châssis du moteur, impliquant notamment de réduire autant que possible l'encombrement induit par le circuit de refroidissement.

Ainsi, la présente invention est destinée à une mise en oeuvre dans le contexte de la mise en liaison fluidique de deux portions de circuits de refroidissement intégrées respectivement à deux boîtiers, en particulier deux boîtiers dans lesquels se trouvent des systèmes électriques. La présente invention est particulièrement adaptée au cas où l'un des boîtiers contient un onduleur et l'autre un moteur électrique, comme détaillé ci-dessus. Cependant, d'autres cas d'utilisation sont prévus. Par exemple, l'un des boîtiers peut comprendre un convertisseur de tension continue-continue et l'autre boîtier un onduleur. Ces exemples sont donnés à titre illustratif et ne doivent pas être interprétés de façon restrictive.

Selon l'état de la technique, pour mettre en liaison fluidique deux portions de circuit de refroidissement intégrées à des boîtiers électriques accolés, des pièces rapportées sont nécessaires. En pratique, dans chaque boîtier, une buse, couramment désignée sous le terme en langue anglaise « nozzle », ou un manchon, couramment désigné sous le terme en langue anglaise « spigot », est inséré de façon à former une entrée ou sortie de fluide, respectivement, pour chaque portion de circuit de refroidissement.

Une telle buse ou un tel manchon de type « spigot » issu d'un boîtier, tel qu'un boîtier de convertisseur de tension continue-continue ou un boîtier d'onduleur par exemple, pénètre une entrée / sortie de fluide d'une portion de circuit de refroidissement intégré à un deuxième boîtier tel que, respectivement, un boîtier d'onduleur ou un boîtier de moteur électrique par exemple.

Lesdites buses ou lesdits manchons respectifs issus d'une ouverture d'un boîtier sont insérés dans une ouverture de l'autre boîtier pour réaliser la mise en liaison fluidique. Le cas échéant, un tuyau est utilisé pour relier lesdites buses ou lesdits manchons issus de chaque boîtier, en particulier lorsque ces derniers ne se trouvent pas parfaitement alignés en vis-à-vis une fois les boîtiers mis en place et accolés.

Ces moyens connus permettant la mise en liaison fluidique deux portions de circuit de refroidissement intégrées à des boîtiers électriques accolés présentent différents inconvénients.

D'abord, le risque de fuite est important, ce qui est fortement préjudiciable, en particulier dans le contexte d'un système de motorisation électrique d'un véhicule.

En outre, ces moyens connus engendrent un encombrement important. En effet, les solutions connues, comprenant l'utilisation de buses ou de manchons, nécessitent un enfoncement de la buse ou du manchon utilisé en profondeur dans chacun des boîtiers, typiquement de l'ordre de 30 mm, afin d'assurer une étanchéité acceptable. De plus, malgré cet enfoncement en profondeur, des fuites restent possibles.

Enfin, pour mettre en oeuvre les solutions connues de l'état de la technique, il faut impérativement que l'entrée et la sortie des portions de circuit de refroidissement à mettre en liaison fluidique, chacune desdites portions étant intégrée à chacun des boîtiers, soient parfaitement alignées. A défaut, un tuyau est nécessaire, avec l'inconvénient d'augmenter encore l'encombrement du système.

Or, en pratique, le nombre de fonctions électriques mises en œuvre, notamment dans un véhicule, augmente, et le volume dédié aux systèmes électriques compris dans les boîtiers, comme le boîtier de l'onduleur, augmente aussi. Cela provoque notamment un décalage et une augmentation du volume du module de puissance de l'onduleur, correspondant à la partie de l'onduleur à refroidir, et induit un désalignement entre la sortie de fluide de la portion de circuit de refroidissement intégrée au boîtier de l'onduleur et l'entrée de fluide de la portion de circuit de refroidissement intégrée au boîtier du moteur électrique utilisé.

La présente invention permet de résoudre au moins en partie les inconvénients précités au moyen d'une mise en liaison fluidique des portions de circuit intégrées à deux boîtiers, notamment deux boîtiers enfermant des systèmes électriques, via un contact plan /plan et de la mise en place d'un joint encerclant la zone dans laquelle la mise en liaison fluidique est réalisée, ledit joint étant comprimé entre les deux boîtiers.

### PRESENTATION GENERALE DE L'INVENTION

Plus précisément, la présente invention consiste en un ensemble de deux boîtiers, selon la revendication 1.

Grâce à l'invention, deux portions de circuit de refroidissement à fluide intégrées à deux boîtiers distincts sont mises en liaison fluidique de façon étanche tout en assurant un encombrement minimisé en l'absence de toute buse, de tout manchon ou équivalent et de tout tuyau.

Selon un mode de réalisation, ledit évidement comporte une section présentant une aire comprise entre 50 mm² et 1600 mm².

Selon un mode de réalisation préféré, ledit évidement présente au moins une portion de bordure arrondie de façon à favoriser l'écoulement de fluide.

Selon un mode de réalisation, l'un des deux boîtiers comprend un convertisseur de tension continue-continue et l'autre boîtier comprend un onduleur.

Selon un mode de réalisation, l'un des deux boîtiers comprend un onduleur et l'autre boîtier comprend un moteur électrique.

Selon un mode de réalisation, chacune des faces mises en contact plan-plan comprend respectivement un évidement configuré de manière à ce que leur périphérie respective englobe à la fois l'ouverture de la première portion de circuit de refroidissement et l'ouverture de la deuxième portion de circuit de refroidissement.

Avantageusement, chacune des faces mises en contact plan-plan présente une rugosité inférieure ou égale à 6,3 µm.

Selon un mode de réalisation, l'ensemble comprend par ailleurs un joint d'étanchéité configuré pour encercler lesdites ouvertures et être mis en compression entre lesdites faces planes lorsque lesdites faces planes sont mises en contact plan-plan.

De cette façon, le dispositif selon l'invention présente aussi l'avantage d'être aisé à mettre en œuvre dans la mesure où, lors de l'assemblage des deux boîtiers adaptés, il suffit de positionner le joint comme il convient puis d'accoler les deux boîtiers adaptés de façon à mettre ledit joint en compression. La mise en liaison fluidique des deux portions de circuit de refroidissement est alors automatique.

Selon un mode de réalisation, les première et deuxième portions de circuit de refroidissement sont configurées pour être mises en liaison fluidique uniquement par ledit contact plan-plan.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 représente un schéma d'un mode de réalisation de l'invention pour la mise en liaison fluidique de deux portions de circuit de refroidissement intégrées à des boîtiers accolés ;
- la figure 2 montre un joint torique destiné à se trouver comprimé entre deux boîtiers accolés pour mettre en œuvre la présente invention ;
- la figure 3 représente la vue d'un évidement pratiqué sur une face d'un boîtier autour d'une entrée ou d'une sortie de fluide d'une portion de circuit de refroidissement intégrée audit boîtier ;
- la figure 4 montre un boîtier présentant un évidement comportant un arrondi configuré pour optimiser l'écoulement de fluide d'une portion de circuit de refroidissement à l'autre.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention.

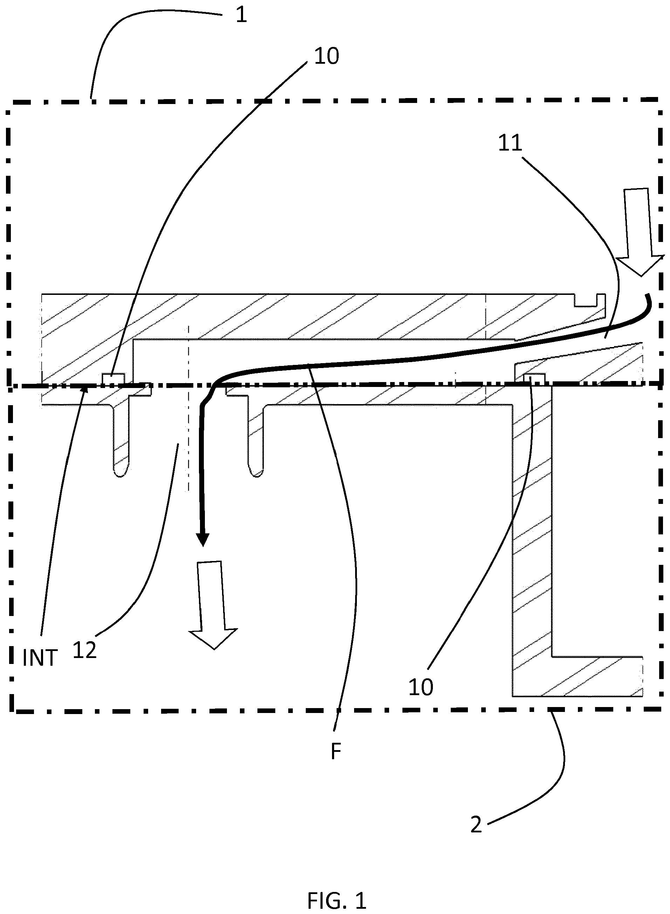

La figure 1 montre un premier mode de réalisation de la présente invention.

Un premier boîtier 1, en particulier un boîtier comprenant un onduleur, et un deuxième boîtier 2, en particulier comprenant un moteur électrique, sont mis en contact plan-plan selon une face respective formant une interface INT entre deux portions de circuit de refroidissement à fluide, en particulier un circuit de refroidissement à eau. Le circuit de refroidissement à fluide partiellement représenté sur la figure 1 est par conséquent formé d'une première portion et d'une deuxième portion intégrées respectivement au premier boîtier 1 et au deuxième boîtier 2. Chaque portion de circuit de refroidissement est formée de canalisations aménagées dans chaque boîtier 1, 2, lesdites canalisations étant aptes à recevoir un fluide de refroidissement F. Sur la figure 1 est représentée en particulier la zone de mise en liaison fluidique des deux portions de circuit de refroidissement.

La première portion de circuit de refroidissement, intégrée au premier boîtier 1, est, selon un mode de réalisation, destinée à refroidir un module de puissance d'un onduleur intégré audit premier boîtier 1.

La deuxième portion de circuit de refroidissement, intégrée au deuxième boîtier 2, est, selon un mode de réalisation, destinée à refroidir un moteur électrique intégré audit deuxième boîtier 2.

Le premier boîtier 1 comprend une sortie de fluide 11 de la première portion de circuit de refroidissement et le deuxième boîtier 2 comprend une entrée de fluide 12 de la deuxième portion de circuit de refroidissement.

Ladite entrée 12 et ladite sortie 11 se trouvent de préférence en vis-à-vis lorsque les deux boîtiers 1, 2 sont accolés. Cependant, le cas échéant, ladite entrée 12 et ladite sortie 11 peuvent ne pas être alignées lorsque les boîtiers 1, 2 sont mis en place et accolés. La présente invention permet notamment de résoudre ce problème technique.

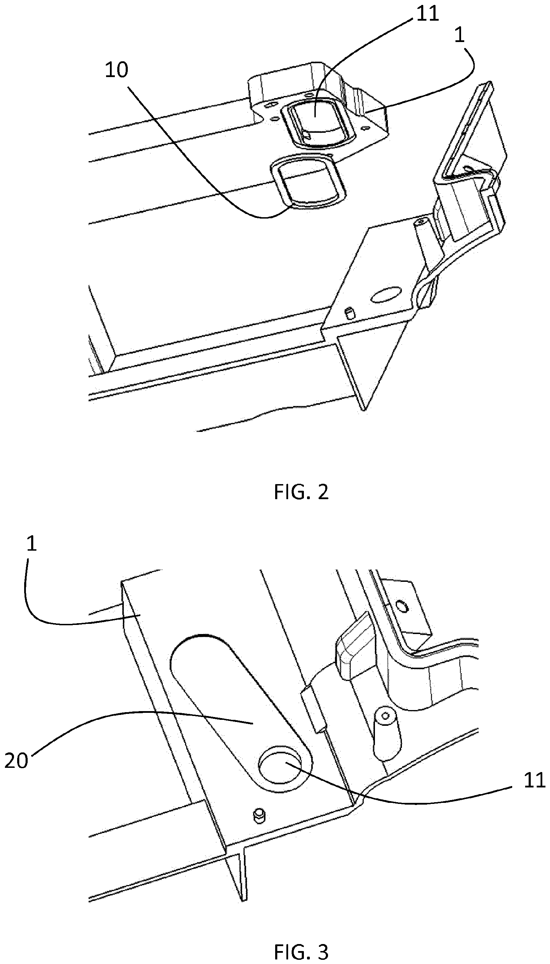

Un joint torique 10, comme sur la figure 2, ou un joint circulaire par exemple, ou un joint de toute forme adaptée, est positionné de façon à encercler ladite entrée 12 et ladite sortie 11 et se trouve mis en compression entre les deux faces des deux boîtiers accolés 1, 2, de telle sorte que la première portion de circuit de refroidissement et la deuxième portion de circuit de refroidissement soient mises en liaison fluidique de façon étanche.

En référence à la figure 3, selon un mode de réalisation, un évidement 20 est prévu, notamment pour parer aux cas où l'entrée 12 de la portion de circuit de refroidissement appartenant au deuxième boîtier 2 et la sortie 11 de la portion de circuit de refroidissement appartenant au premier boîtier 1 ne sont pas parfaitement alignées lorsque lesdits boîtiers 1, 2 sont mis en place et accolés.

Comme représenté à la figure 3, un tel évidement 20 est alors aménagé sur l'une au moins des faces des deux boîtiers accolés 1, 2. L'évidement 20 s'étend depuis l'ouverture 11, 12 de la portion de circuit de refroidissement débouchant de la face sur laquelle ledit évidement 20 est aménagé, ladite ouverture 11, 12 formant une entrée 12 ou une sortie 11 de ladite portion de circuit de refroidissement.

Ledit évidement 20 est configuré de manière à ce que sa périphérie englobe, en plus, par construction, de l'entrée 12 ou sortie 11 de la portion de circuit de refroidissement de la face de boîtier à laquelle il appartient, également l'entrée 12 ou la sortie 11 de l'autre portion de circuit de refroidissement, située sur la face de l'autre boîtier.

Grâce audit évidement 20, le fluide F issu de la sortie 11 de la première portion de circuit est acheminé, via l'évidement 20, jusqu'à l'entrée 12 de la deuxième portion de circuit de refroidissement, le joint 10 mis en compression entre les deux boîtiers accolés assurant l'étanchéité.

Un tel évidement 20 permet de favoriser l'écoulement du fluide F dans le circuit de refroidissement formé par les portions de circuit intégrées à chacun des boîtiers.

De préférence, ledit évidement 20 présente une hauteur adaptée pour favoriser l'écoulement du fluide de la première portion de circuit de refroidissement à la deuxième portion de circuit de refroidissement. Selon un mode de réalisation préféré, ledit évidement 20 est présent sur un seul des boîtiers 1, 2 tandis que l'autre boîtier 1, 2 présente une planéité de très bonne qualité. Par exemple, la rugosité de la face du boîtier 1, 2 ne comprenant pas d'évidement est de préférence inférieure à 6,3 µm.

En l'absence d'évidement, la planéité des faces des deux boîtiers 1, 2 accolés doit de préférence être de très bonne qualité, avec de préférence une rugosité inférieure à 6,3 µm.

Un évidement 20 peut également être prévu sur les deux faces accolées.

Selon un mode de réalisation, ledit (lesdits) évidement(s) 20 peut (peuvent) comprendre une portion de bordure arrondie pour favoriser l'écoulement de fluide.

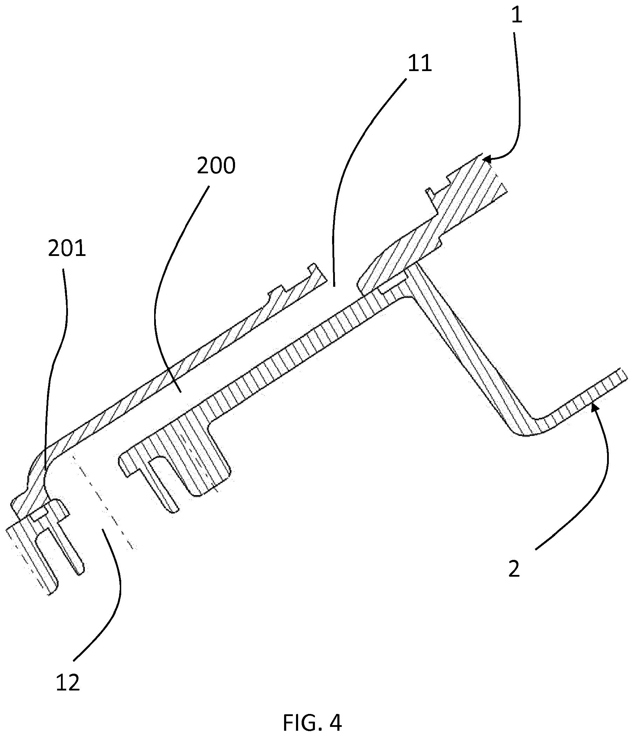

En référence à la figure 4, un évidement 200 est ainsi aménagé, uniquement sur une face ou sur les deux faces accolées, et comprend une portion de bordure arrondie 201, présentant un rayon de courbure adapté pour favoriser l'écoulement du fluide via ledit évidement 200 lors de son passage de la première portion de circuit de refroidissement à la deuxième portion de circuit de refroidissement.

La portion de bordure arrondie 201 favorise l'écoulement du fluide F et donc la vitesse à laquelle le fluide F peut circuler dans le circuit de refroidissement, améliorant de ce fait l'efficacité du circuit de refroidissement.

En résumé, au moyen d'un contact plan-plan entre les faces de deux boîtiers 1, 2 accolés comprenant chacun une portion de circuit de refroidissement à fluide F, la présente invention permet d'assurer la mise en liaison fluidique, de façon étanche, desdites deux portions de circuit de refroidissement. A cette fin, la sortie 11 de la première portion de circuit de refroidissement, débouchant de la face du premier boîtier 1, et l'entrée 12 de la deuxième portion de circuit de refroidissement, débouchant de la face du deuxième boîtier 2, sont reliées l'une à l'autre au moyen du contact plan-plan établi entre lesdites deux faces et d'un joint 10, comprimé entre lesdites deux faces, assurant l'étanchéité de la mise en liaison fluidique.

Selon un mode de réalisation préféré, l'une au moins desdites faces comporte un évidement 20, 200, pouvant présenter une portion de bordure arrondie 201, dont la périphérie englobe à la fois l'entrée 12 ou la sortie 11 de fluide de la face à laquelle il appartient et l'entrée 12 ou la sortie 11, respectivement, appartenant à la face de l'autre boîtier 1, 2.

Dans ce dernier cas, le fluide F est acheminé, via l'évidement 20, 200, de la sortie 11 de la première portion de circuit de refroidissement à l'entrée 12 de la deuxième portion de circuit de refroidissement, de façon étanche, grâce au joint 10, et de manière à présenter un encombrement minimum, en l'absence de toute buse ou de tout manchon ou encore de tout tuyau.

## Revendications

1. Ensemble de deux boîtiers (1, 2), un premier boîtier (1) comprenant une première portion de circuit de refroidissement et un deuxième boîtier (2) comprenant une deuxième portion de circuit de refroidissement, lesdites portions de circuit de refroidissement étant destinées à former un circuit de refroidissement à fluide (F), chaque boîtier (1, 2) comprenant une face plane comprenant une ouverture (11, 12) de portion de circuit de refroidissement respective et définissant une interface (INT) dudit circuit de refroidissement, lesdites portions de circuit de refroidissement étant destinées à être mises en liaison fluidique par un contact plan-plan entre lesdites faces planes, lesdites ouvertures (11, 12) étant disposées sensiblement en vis-à-vis, l'une desdites ouvertures (11, 12) formant une entrée (12) d'une portion de circuit de refroidissement et l'autre desdites ouvertures (11, 12) formant une sortie (11) d'une portion de circuit de refroidissement, dans lequel l'une au moins des ouvertures (11, 12) comprend par ailleurs un évidement (20, 200) aménagé dans la face plane correspondante et s'étendant depuis ladite ouverture (11, 12) de façon à ce que la périphérie dudit évidement (20, 200) englobe également l'autre desdites ouvertures (11, 12) lorsque les faces planes sont en contact plan-plan, permettant d'assurer une mise en liaison fluidique des deux portions de circuit de refroidissement, y compris lorsque l'entrée (12) et la sortie (11) sont désalignées, **caractérisé en ce que** ledit premier boîtier (1) et ledit deuxième boîtier (2) comprennent respectivement un équipement électrique.

2. Ensemble de deux boîtiers (1, 2) selon la revendication précédente, ledit évidement (20, 200) comportant une section présentant une aire comprise entre 50 mm² et 1600 mm².

3. Ensemble de deux boîtiers selon l'une des revendications 1 à 2, ledit évidement (20, 200) présentant au moins une portion de bordure arrondie (201) de façon à favoriser l'écoulement de fluide.

4. Ensemble de deux boîtiers (1, 2) selon l'une des revendications précédentes, l'un des deux boîtiers (1, 2) comprenant un convertisseur de tension continue-continue et l'autre boîtier (1, 2) comprenant un onduleur.

5. Ensemble de deux boîtiers (1, 2) selon l'une des revendications 1 à 3, l'un des deux boîtiers (1, 2) comprenant un onduleur et l'autre boîtier (1, 2) comprenant un moteur électrique.

6. Ensemble de deux boîtiers (1, 2) selon l'une des revendications précédentes, dans lequel chacune des faces mises en contact plan-plan comprend respectivement un évidement (20, 200) configuré de manière à ce que leur périphérie respective englobe à la fois l'ouverture (11, 12) de la première portion de circuit de refroidissement et l'ouverture (11, 12) de la deuxième portion de circuit de refroidissement.

7. Ensemble de deux boîtiers (1, 2) selon l'une des revendications précédentes, dans lequel chacune des faces mises en contact plan-plan présente une rugosité inférieure à 6,3 µm.

8. Ensemble de deux boîtiers (1, 2) selon l'une des revendications précédentes, comprenant par ailleurs un joint d'étanchéité (10) configuré pour encercler lesdites ouvertures (11, 12) et être mis en compression entre lesdites faces planes lorsque lesdites faces planes sont mises en contact plan-plan.

9. Ensemble de deux boîtiers (1, 2) selon l'une des revendications précédentes, dans lequel les première et deuxième portions de circuit de refroidissement sont configurées pour être mises en liaison fluidique uniquement par ledit contact plan-plan.

## Patentansprüche

1. Anordnung aus zwei Gehäusen (1, 2), wobei ein erstes Gehäuse (1) einen ersten Kühlkreislaufabschnitt umfasst und ein zweites Gehäuse (2) einen zweiten Kühlkreislaufabschnitt umfasst, wobei die Kühlkreislaufabschnitte dazu bestimmt sind, einen Fluid-(F)-Kühlkreislauf zu bilden, wobei jedes Gehäuse (1, 2) eine ebene Fläche umfasst, die eine jeweilige Kühlkreislaufabschnittöffnung (11, 12) umfasst und eine Schnittstelle (INT) des Kühlkreislaufs definiert, wobei die Kühlkreislaufabschnitte dazu bestimmt sind, durch einen Eben-Eben-Kontakt zwischen den ebenen Flächen in Fluidverbindung gebracht zu werden, wobei die Öffnungen (11, 12) im Wesentlichen einander gegenüber angeordnet sind, wobei eine der Öffnungen (11, 12) einen Eingang (12) eines Kühlkreislaufabschnitts bildet und die andere der Öffnungen (11, 12) einen Ausgang (11) eines Kühlkreislaufabschnitts bildet, wobei die mindestens eine der Öffnungen (11, 12) ferner eine Aussparung (20, 200) umfasst, die in der entsprechenden ebenen Fläche ausgeführt ist und sich so von der Öffnung (11, 12) erstreckt, dass der Umfang der Aussparung (20, 200) auch die andere der Öffnungen (11, 12) einschließt, wenn die ebenen Flächen in Eben-Eben-Kontakt sind, wodurch die Herstellung einer fluidischen Verbindung zwischen den beiden Kühlkreislaufabschnitten gewährleistet werden kann, einschließlich dann, wenn der Eingang (12) und der Ausgang (11) versetzt sind, **dadurch gekennzeichnet, dass** das erste Gehäuse (1) und das zweite Gehäuse (2) jeweils eine elektrische Vorrichtung umfassen.

2. Anordnung aus zwei Gehäusen (1, 2) nach dem vorhergehenden Anspruch, wobei die Aussparung (20, 200) einen Querschnitt aufweist, der eine Fläche zwischen 50 mm² und 1600 mm² aufweist.

3. Anordnung aus zwei Gehäusen nach einem der Ansprüche 1 bis 2, wobei die Aussparung (20, 200) mindestens einen abgerundeten Umrandungsabschnitt (201) aufweist, so dass die Fluidströmung begünstigt wird.

4. Anordnung aus zwei Gehäusen (1, 2) nach einem der vorhergehenden Ansprüche, wobei eines der beiden Gehäuse (1, 2) einen Gleichspannungswandler umfasst und das andere Gehäuse (1, 2) einen Wechselrichter umfasst.

5. Anordnung aus zwei Gehäusen (1, 2) nach einem der Ansprüche 1 bis 3, wobei eines der beiden Gehäuse (1, 2) einen Wechselrichter umfasst und das andere Gehäuse (1, 2) einen Elektromotor umfasst.

6. Anordnung aus zwei Gehäusen (1, 2) nach einem der vorhergehenden Ansprüche, wobei jede der Flächen, die in Eben-Eben-Kontakt gebracht worden sind, jeweils eine Aussparung (20, 200) umfasst, die so ausgestaltet ist, dass ihr Umfang sowohl die Öffnung (11, 12) des ersten Kühlkreislaufabschnitts als auch die Öffnung (11, 12) des zweiten Kühlkreislaufabschnitts einschließt.

7. Anordnung aus zwei Gehäusen (1, 2) nach einem der vorhergehenden Ansprüche, wobei jede der Flächen, die in Eben-Eben-Kontakt gebracht worden sind, eine Rauheit von weniger als 6,3 µm aufweist.

8. Anordnung aus zwei Gehäusen (1, 2) nach einem der vorhergehenden Ansprüche, umfassend ferner eine Dichtung (10), die dazu ausgestaltet ist, die Öffnungen (11, 12) zu umgeben und zwischen den ebenen Flächen komprimiert zu werden, wenn die ebenen Flächen in Eben-Eben-Kontakt gebracht werden.

9. Anordnung aus zwei Gehäusen (1, 2) nach einem der vorhergehenden Ansprüche, wobei der erste und der zweite Kühlkreislaufabschnitt dazu ausgestaltet sind, einzig und allein durch den Eben-Eben-Kontakt in Fluidverbindung gebracht zu werden.

## Claims

1. Set of two units (1, 2), a first unit (1) comprising a first cooling circuit portion and a second unit (2) comprising a second cooling circuit portion, said cooling circuit portions being intended to form a fluid cooling circuit (F), each unit (1, 2) comprising a flat face comprising a respective cooling circuit portion opening (11, 12) and defining an interface (INT) of said cooling circuit, said cooling circuit portions being intended to be fluidically linked by a plane-plane contact between said flat faces, said openings (11, 12) being disposed substantially opposite one another, one of said openings (11, 12) forming an inlet (12) of a cooling circuit portion and the other of said openings (11, 12) forming an outlet (11) of a cooling circuit portion, wherein at least one of the openings (11, 12) also comprises a gap (20, 200) formed in the corresponding flat face and extending from said opening (11, 12) so that the periphery of said gap (20, 200) also encompasses the other of said openings (11, 12) when the flat faces are in plane-plane contact, allowing a fluidic linking of the two cooling circuit portions to be assured, including when the inlet (12) and the outlet (2) are misaligned, **characterized in that** said first unit (1) and said second unit (2) respectively comprise an electrical device.

2. Set of two units (1, 2) according to the preceding claim, said gap (20, 200) comprising a section having an area of between 50 mm² and 1600 mm².

3. Set of two units according to one of Claims 1 and 2, said gap (20, 200) having at least one rounded rim portion (201) so as to promote the flow of fluid.

4. Set of two units (1, 2) according to one of the preceding claims, one of the two units (1, 2) comprising a DC-DC voltage converter and the other unit (1, 2) comprising an inverter.

5. Set of two units (1, 2) according to one of Claims 1 to 3, one of the two units (1, 2) comprising an inverter and the other unit (1, 2) comprising an electric motor.

6. Set of two units (1, 2) according to one of the preceding claims, wherein each of the two faces placed in plane-plane contact respectively comprises a gap (20, 200) configured so that their respective periphery encompasses both the opening (11, 12) of the first cooling circuit portion and the opening (11, 12) of the second cooling circuit portion.

7. Set of two units (1, 2) according to one of the preceding claims, wherein each of the faces placed in plane-plane contact has a roughness less than 6.3 µm.

8. Set of two units (1, 2) according to one of the preceding claims, also comprising a seal (10) configured to encircle said openings (11, 12) and be compressed between said flat faces when said flat faces are placed in plane-plane contact.

9. Set of two units (1, 2) according to one of the preceding claims, wherein the first and second cooling circuit portions are configured to be fluidically linked only by said plane-plane contact.
